# EUROPEAN PATENT SPECIFICATION

(11) **EP 4 033 552 B1**
(45) Date of publication and mention of the grant of the patent: **12.06.2024**
(21) Application number: 20866135.5
(22) Date of filing: 31.08.2020
(51) Int. Cl.: H01B 12/06, H10N 60/81

(54) **SUPERCONDUCTING WIRE HOLDING STRUCTURE**
STRUKTUR ZUM HALTEN EINES SUPRALEITENDEN DRAHTES
STRUCTURE DE MAINTIEN DE FIL SUPRACONDUCTEUR

(30) Priority: 20.09.2019 JP 2019171839
(43) Date of publication of application: 27.07.2022
(73) Proprietor: SUMITOMO ELECTRIC INDUSTRIES, LTD., Osaka-shi, Osaka 541-0041 (JP); RIKEN, Wako-shi Saitama 351-0198 (JP); Japan Superconductor Technology, Inc., Kobe-shi, Hyogo 651-2271 (JP)
(72) Inventor: YAMAGUCHI, Takashi, Osaka-shi, Osaka 541-0041 (JP); OHKI, Kotaro, Osaka-shi, Osaka 541-0041 (JP); NAGAISHI, Tatsuoki, Osaka-shi, Osaka 541-0041 (JP); YANAGISAWA, Yoshinori, Wako-shi, Saitama 351-0198 (JP); HAMADA, Mamoru, Kobe-shi, Hyogo 651-2271 (JP)
(74) Representative: Grünecker Patent- und Rechtsanwälte PartG mbB
(86) International application number: PCT/JP2020/032809
(87) International publication number: WO 2021/054093

(56) References cited:
- WO-A1-2018/078876
- WO-A1-2018/181561
- JP-A- S5 112 790
- JP-A- 2011 165 435
- JP-A- 2019 160 818
- US-A1- 2006 073 979
- US-A1- 2018 204 658

## Description

### TECHNICAL FIELD

The present disclosure relates to a superconducting wire holding structure.

### BACKGROUND ART

PTL 1 (WO 2018 / 181 561 A1) describes a superconducting wire material holding structure. The superconducting wire holding structure described in PTL 1 includes a holding member and a superconducting wire disposed inside the holding member.

### CITATION LIST

### PATENT LITERATURE

PTL 1: WO 2018 / 181 561 A1

Document WO 2018 / 078 876 A1 relates to a superconducting wire comprising a main body, a substrate and a cover. The main body includes a superconducting material part having a first principle surface and a second principle surface positioned opposite of the first principle surface. The substrate supports the second principal surface of the main body. The cover is formed at least on the first principle surface of the main body. In the cover, the surface roughness of the center portion of the superconducting wire in the width direction is less than the surface roughness of the edges thereof in the width direction.

Document US 2018 / 204 658 A1 relates to a superconducting wire. The superconducting wire has a first superconducting wire rod having a first front surface, a first back surface, a first superconducting layer, and first reinforcing layers, and a second superconducting wire rod having a second front surface, a second back surface, a second superconducting layer, and second reinforcing layers; and a connection member joining the first superconducting wire rod to the second superconducting wire rod. The first superconducting wire rod has a first edge portion, and the second superconducting wire rod has a second edge portion. The first front surface located at the first edge portion is joined by the connection member to the second front surface located at a portion other than the second edge portion, and the second front surface located at the second edge portion is joined by the connection member to the first front surface located at a portion other than the first edge portion.

Document US 2006 / 073 979 A1 relates to a laminated superconductor wire including a superconductor wire assembly, which includes a first superconductor insert comprising a first high temperature superconductor layer overlaying a first substrate and a second superconductor insert comprising a second high temperature superconductor layer overlaying a second substrate. The first and second superconductor inserts are joined together at their respective substrates. An electrically conductive structure substantially surrounds the superconductor wire assembly.

### SUMMARY OF INVENTION

A superconducting wire holding structure according according to independent device claims 1 and 12.

### BRIEF DESCRIPTION OF DRAWINGS

Fig. 1 is a schematic view illustrating a superconducting wire holding structure according to a first embodiment.
Fig. 2 is a sectional view taken along a line II-II in Fig. 1.
Fig. 3 is a top view illustrating a superconducting wire 2 in the superconducting wire holding structure of the first embodiment.
Fig. 4 is a sectional view taken along a line IV-IV in Fig. 3.
Fig. 5 is a sectional view taken along a line V-V in Fig. 3.
Fig. 6 is a sectional view taken along a line VI-VI in Fig. 3.
Fig. 7 is an exploded perspective view illustrating the superconducting wire 2 and a heater 4 in the superconducting wire holding structure of the first embodiment.
Fig. 8 is a schematic diagram illustrating a configuration of a persistent current switch 5.
Fig. 9 is a process diagram illustrating a method for manufacturing the superconducting wire holding structure of the first embodiment.
Fig. 10 is a sectional view illustrating the superconducting wire holding structure of the first embodiment in a preparation process S1.
Fig. 11 is a schematic sectional view illustrating a superconducting wire holding structure according to a second embodiment.
Fig. 12 is a sectional view taken along a line XII-XII in Fig. 11.
Fig. 13 is a sectional perspective view illustrating a superconducting wire 8 in the superconducting wire holding structure of the second embodiment.
Fig. 14 is a sectional perspective view illustrating a superconducting wire 9 in the superconducting wire holding structure of the second embodiment.
Fig. 15 is a process diagram illustrating a method for manufacturing the superconducting wire holding structure of the second embodiment.

### DETAILED DESCRIPTION

### [Problem to be Solved by the Present Disclosure]

In a case where there is a gap between the holding member and the superconducting wire when the superconducting wire holding structure is returned from a cryogenic temperature (for example, liquid nitrogen temperature, liquid helium temperature) to a normal temperature, dew condensation is generated on the surface of the superconducting wire during returning of the superconducting wire holding structure from the cryogenic temperature to the normal temperature. The dew condensation generated on the surface of the superconducting wire causes degradation of a superconducting characteristic of the superconducting wire.

The present disclosure has been made in view of the above-described problems of the prior art. More specifically, the present disclosure provides a superconducting wire holding structure capable of preventing the dew condensation from being generated on the surface of the superconducting wire when the temperature is returned from the cryogenic temperature to the normal temperature.

### [Advantageous Effect of the Present Disclosure]

According to the above, the dew condensation can be prevented from being generated on the surface of the superconducting wire when the superconducting wire holding structure is returned from the cryogenic temperature to the normal temperature.

### [Description of Embodiments]

First, embodiments of the present disclosure will be listed and described.
(1) A superconducting wire holding structure according to an embodiment includes a holding member made of a first material, a superconducting wire disposed inside the holding member, and a filler made of a second material different from the first material. The superconducting wire includes a substrate, an intermediate layer formed on the substrate, a superconducting layer formed on the intermediate layer, and a first protective layer and a second protective layer that are formed on the superconducting layer. The superconducting layer includes a first portion, a second portion, and a third portion between the first portion and the second portion along a longitudinal direction of the superconducting wire. The first protective layer is formed on the first portion, and the second protective layer is formed on the second portion. The filler is filled between the third portion and the holding member.
   According to the superconducting wire holding structure of (1), a space between the holding member and the superconducting wire is filled with the filler, so that the dew condensation can be prevented from being generated on the surface of the superconducting wire (more specifically, the surface of the third portion of the superconducting layer) when the temperature is returned from the cryogenic temperature to the normal temperature.
(2) In the superconducting wire holding structure of (1), the first material may be a first resin material, and the second material may be a second resin material.
(3) In the superconducting wire holding structure of (2), the glass transition point (when the second resin material is crystalline, a melting point) of the second resin material may be lower than the glass transition point (when the first resin material is crystalline, a melting point) of the first resin material. In this case, the filler can be easily filled between the holding member and the superconducting wire.
(4) In the superconducting wire holding structure of (2), viscosity of the second resin material may be lower than viscosity of the first resin material. In this case, the filler can be easily filled between the holding member and the superconducting wire.
(5) In the superconducting wire holding structure of (2) to (4), the first resin material may be a thermosetting resin, and the second resin material may be a thermoplastic resin.
(6) In the superconducting wire holding structure of (2) to (5), the second resin material may be paraffin.
(7) The superconducting wire holding structures (1) to (6) may constitute a persistent current switch.
(8) In the superconducting wire holding structure of (1), the first material may be a resin material, and the second material may be a metal material. The melting point of the metal material may be lower than the glass transition point (when the resin material is crystalline, the melting point) of the resin material. In this case, the filler can be easily filled between the holding member and the first portion and the second portion.
(9) In the superconducting wire holding structure of (8), the resin material may be a thermosetting resin.
(10) In the superconducting wire holding structure of (8) or (9), the melting point of the metal material may be less than or equal to 200°C.
(11) In the superconducting wire holding structure of (8) to (10), the metal material may be a bismuth-based alloy.
(12) A superconducting wire holding structure according to another embodiment includes a first superconducting wire that includes a first superconducting layer, a second superconducting wire that includes a second superconducting layer, a holding member made of a first material, and a filler made of a second material different from the first material. The first superconducting wire includes a first portion where the first superconducting layer is exposed from a surface of the first superconducting wire at an end in a longitudinal direction of the first superconducting wire. The second superconducting wire includes a second portion where the second superconducting layer is exposed from a surface of the second superconducting wire at an end in a longitudinal direction of the second superconducting wire. The first portion and the second portion are disposed inside the holding member. The first superconducting layer located in the first portion and the second superconducting layer located in the second portion are connected to each other. The filler is filled between the holding member and the first portion and the second portion. In the superconducting wire holding structure the first material is a first resin material, and the second material is a second resin material.
(13) In the superconducting wire holding structure of (12), the glass transition point (when the second resin material is crystalline, the melting point) of the second resin material may be lower than the glass transition point (when the first resin material is crystalline, the melting point) of the first resin material. In this case, the filler can be easily filled between the holding member and the superconducting wire.
(14) In the superconducting wire holding structure of (12), viscosity of the second resin material may be lower than viscosity of the first resin material. In this case, the filler can be easily filled between the holding member and the superconducting wire.
(15) In the superconducting wire holding structure of (12) to (14), the first resin material may be a thermosetting resin, and the second resin material may be a thermoplastic resin.
(16) In the superconducting wire holding structure of (12) to (15), the second resin material may be paraffin.

### Detailed Embodiments of the Present Disclosure

With reference to the drawings, details of embodiments will be described. In the drawings, the same or corresponding portion is denoted by the same reference numeral, and the description will not be repeated.

### (First embodiment)

Hereinafter, a configuration of a superconducting wire holding structure according to a first embodiment will be described.

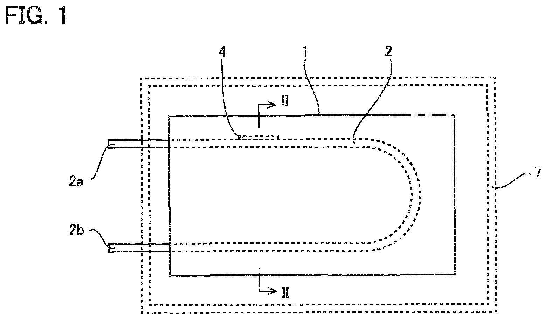

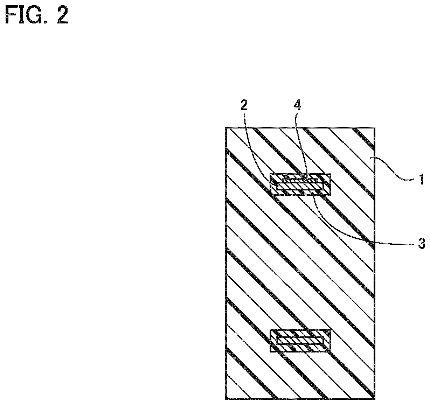

Fig. 1 is a schematic view illustrating the superconducting wire holding structure of the first embodiment. Fig. 2 is a sectional view taken along a line II-II in Fig. 1. As illustrated in Figs. 1 and 2, the superconducting wire holding structure of the first embodiment includes a holding member 1, a superconducting wire 2, and a filler 3. The superconducting wire holding structure of the first embodiment may further include a heater 4.

Holding member 1 is made of a first material. For example, the first material is a resin material (first resin material). The first material may be a thermosetting resin material. A specific example of the first material is an epoxy resin. For example, the first material may be an engineering plastic or a fiber reinforced plastic (FRP). Holding member 1 is a member that prevents deformation of the superconducting wire caused by stress due to electromagnetic force applied to a superconducting wire 2.

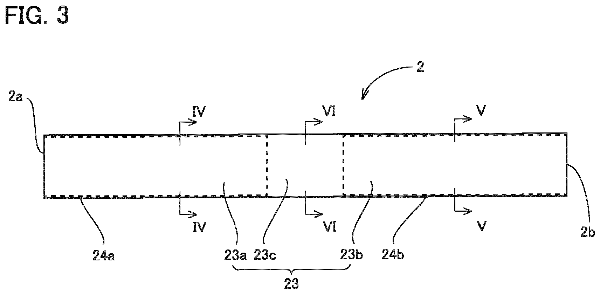

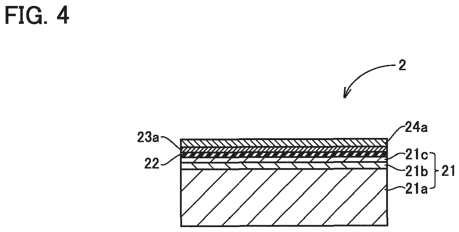

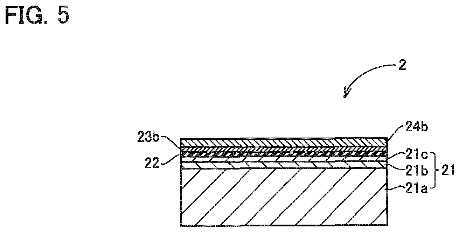

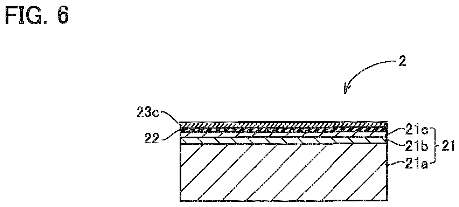

Superconducting wire 2 is disposed inside holding member 1. Superconducting wire 2 may be curved inside holding member 1. Superconducting wire 2 includes a first end 2a and a second end 2b. First end 2a and second end 2b are ends in the longitudinal direction of superconducting wire 2. Second end 2b is an end opposite to first end 2a. Superconducting wire 2 may be drawn out to an outside of holding member 1 at first end 2a and second end 2b. Fig. 3 is a top view illustrating superconducting wire 2 in the superconducting wire holding structure of the first embodiment. Fig. 4 is a sectional view taken along a line IV-IV in Fig. 3. Fig. 5 is a sectional view taken along a line V-V in Fig. 3. Fig. 6 is a sectional view taken along a line VI-VI in Fig. 3. In Fig. 3, a protective layer 24a and a protective layer 24b are indicated by dotted lines. As illustrated in Figs. 3 to 6, superconducting wire 2 includes a substrate 21, an intermediate layer 22, a superconducting layer 23, protective layer 24a, and protective layer 24b.

Substrate 21 includes a first layer 21a, a second layer 21b, and a third layer 21c. For example, first layer 21a is made of stainless steel. Second layer 21b is formed on first layer 21a. For example, second layer 21b is made of copper (Cu). Third layer 21c is formed on second layer 21b. For example, third layer 21c is made of nickel (Ni).

Intermediate layer 22 is formed above substrate 21 (more specifically, third layer 21c). Intermediate layer 22 is made of an insulating material. For example, intermediate layer 22 is made of stabilized zirconia (YSZ), yttrium oxide (Y₂O₃), or cerium oxide (CeO₂). The material constituting intermediate layer 22 is not limited thereto.

Superconducting layer 23 includes a first portion 23a, a second portion 23b, and a third portion 23c along the longitudinal direction of superconducting wire 2. Third portion 23c is located between first portion 23a and second portion 23b in the longitudinal direction of superconducting wire 2.

For example, superconducting layer 23 is made of an oxide superconductor. An example of the oxide superconductor is REBaCu₃O_{y} (RE is a rare earth element). For example, the rare earth element is yttrium (Y), praseodymium (Pr), neodymium (Nd), samarium (Sm), europium (Eu), gadolinium (Gd), holmium (Ho), or ytterbium (Yb).

Protective layer 24a is formed on first portion 23a. Protective layer 24b is formed on second portion 23b. The protective layer is not formed on third portion 23c (the protective layer is partially removed on third portion 23c). Thus, protective layer 24a and protective layer 24b are electrically separated from each other. As a result, even when superconducting layer 23 (third portion 23c) is brought into a normal conducting state by heating by heater 4, current flowing through superconducting layer 23 is not bypassed to protective layer 24a and protective layer 24b, but resistance of superconducting wire 2 can be increased by heating by heater 4. For example, the protective layer is partially removed by etching.

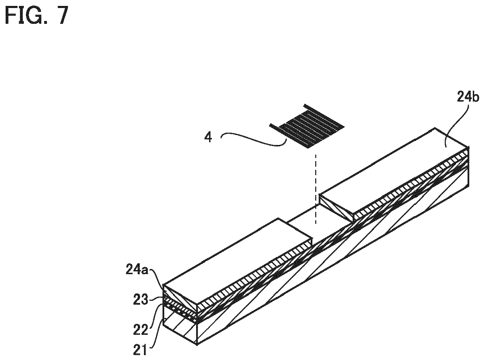

Fig. 7 is an exploded perspective view illustrating superconducting wire 2 and heater 4 in the superconducting wire holding structure of the first embodiment. As illustrated in Fig. 7, heater 4 is attached to superconducting wire 2 so as to face third portion 23c. As illustrated in Fig. 1, superconducting wire 2 is held inside holding member 1 while heater 4 is attached to superconducting wire 2. Heater 4 is formed of an electric heating wire such as a nichrome wire.

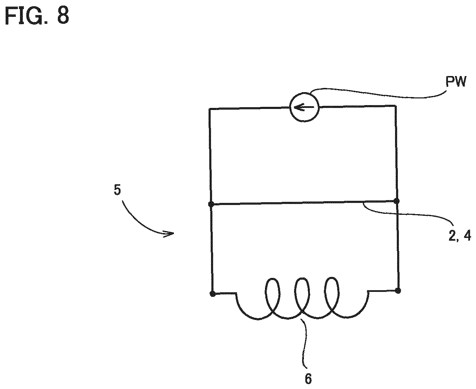

Superconducting wire 2 and heater 4 constitute a persistent current switch 5. Fig. 8 is a schematic diagram illustrating a configuration of persistent current switch 5. As illustrated in Fig. 8, superconducting wire 2 and a superconducting coil 6 are connected in parallel to a power source PW.

When heater 4 is in an off state (when the current does not flow through heater 4), superconducting coil 6 has coil impedance, so that the current flows exclusively through superconducting layer 23 in superconducting wire 2 that becomes the superconducting state. Accordingly, superconducting coil 6 is not excited (this state is referred to as a first state).

When heater 4 is turned on (when the current flows through heater 4), superconducting layer 23 (third portion 23c) in superconducting wire 2 becomes the normal conducting state. When the current gradually flows in this state, the current also starts to flow through superconducting coil 6 (this state is referred to as a second state). When a predetermined time elapses after a desired current flows, the current does not flow through superconducting wire 2, but the current flows exclusively through superconducting coil 6 (this state is referred to as a third state).

When heater 4 is turned off again after being in the third state, superconducting layer 23 (third portion 23c) in superconducting wire 2 returns to the superconducting state. When the current supplied from power source PW is gradually reduced in this state, a part of the current flowing through superconducting coil 6 flows through superconducting wire 2 (this state is referred to as a fourth state).

When the current supplied from power source PW gradually decreases to 0 ampere, the current flows only through superconducting wire 2 and superconducting coil 6 (this state is referred to as a fifth state). When the fifth state is reached, even when power source PW is cut off, the current continues to flow through superconducting wire 2 and superconducting coil 6 (persistent current mode). In this way, persistent current switch 5 can operate superconducting coil 6 in the persistent current mode.

As illustrated in Fig. 2, filler 3 is filled between holding member 1 and superconducting wire 2 (and heater 4). Filler 3 is made of the second material. The second material is a material different from the first material.

The second material is a resin material (second resin material). When the first material is a thermosetting resin material, the second material may be a thermoplastic resin material. When the first material and the second material are resin materials, the glass transition point of the second material (the melting point of the second material when the first material and the second material are crystalline resin materials. the same applies to the following) is less than the glass transition point of the first material. The viscosity of the second resin material is preferably lower than the viscosity of the first resin material. The viscosity of the first resin material and the viscosity of the second resin material are measured by a method defined in JIS Z 8803: 2011. When the viscosity of the first resin material and the viscosity of the second resin material are compared at the same temperature and when the latter is lower than the former, "the viscosity of the second resin material is lower than the viscosity of the first resin material".

For example, a specific example of the second material is paraffin. The second material may be a foamed resin material. The second material may be a metal material. The melting point of the metal material is lower than the glass transition point of the first material (resin material). The melting point of the metal material is preferably less than or equal to 200°C. A specific example of the metal material is a bismuth-based alloy. The "bismuth-based alloy" is an alloy containing bismuth (Bi) as a main component (a component having the highest content in the alloy). For example, examples of the bismuth-based alloy include a rose alloy and a Newton alloy. A type, component, amount, and the like of the second material are appropriately selected according to a condition required for the persistent current switch.

As illustrated in Fig. 1, superconducting wire 2 is disposed and cooled inside case 7, so that superconducting wire 2 is held at a temperature lower than or equal to the superconducting transition temperature. For example, this cooling is performed by liquid nitrogen or liquid helium.

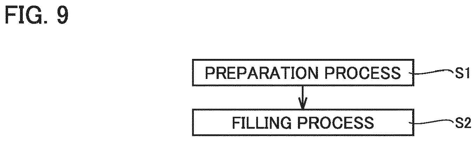

Hereinafter, a method for manufacturing the superconducting wire holding structure of the first embodiment will be described. Fig. 9 is a process diagram illustrating the method for manufacturing the superconducting wire holding structure of the first embodiment. As illustrated in Fig. 9, the method for manufacturing the superconducting wire holding structure of the first embodiment includes a preparation process S1 and a filling process S2.

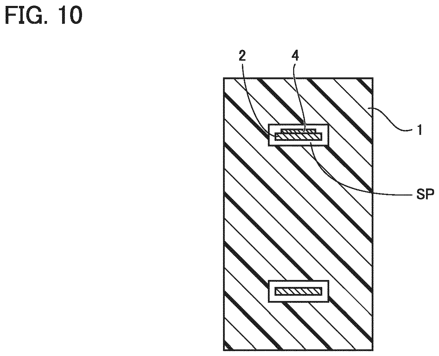

In preparation process S1, holding member 1 in which superconducting wire 2 is held is prepared. Fig. 10 is a sectional view illustrating the superconducting wire holding structure of the first embodiment in preparation process S1. As illustrated in Fig. 10, in preparation process S1, a void SP remains between holding member 1 and superconducting wire 2.

In filling process S2, filler 3 is filled between superconducting wire 2 and holding member 1 (in void SP). Filling process S2 will be specifically described with respect to the case where the first material and the second material are resin materials.

In filling process S2, firstly holding member 1 and filler 3 are heated. The heating temperature at this time is a temperature higher than or equal to the glass transition point of the second material and lower than the glass transition point of the first material. Filler 3 can easily flow by this heating. In filling process S2, after this heating is performed, filler 3 is poured between holding member 1 and superconducting wire 2.

Filler 3 may be filled between holding member 1 and superconducting wire 2 by immersing holding member 1 in which superconducting wire 2 is held in filler 3 heated to be in the flowing state.

When poured filler 3 is cooled and solidified, a space between holding member 1 and superconducting wire 2 is filled with filler 3. As described above, the superconducting wire holding structure of the first embodiment in Figs. 1 and 2 is formed.

Hereinafter, an effect of the superconducting wire holding structure of the first embodiment will be described. The superconducting wire holding structure is returned from the cryogenic temperature to the normal temperature. When there is the gap between the holding member and the superconducting wire, dew condensation is generated on the surface of the superconducting wire when the superconducting wire holding structure is returned from an extremely low temperature to the normal temperature. The dew condensation generated on the surface of the superconducting wire causes degradation of a superconducting characteristic of the superconducting wire.

In the superconducting wire holding structure of the first embodiment, filler 3 is filled between holding member 1 and superconducting wire 2. That is, the surface of superconducting wire 2 is covered with filler 3. For this reason, even when the superconducting wire holding structure of the first embodiment is returned from the cryogenic temperature to the normal temperature, the dew condensation is hardly generated on the surface of superconducting wire 2.

When both the first material and the second material are resin materials and when the glass transition point of the second material is lower than the glass transition point of the first material, holding member 1 is not softened, but filler 3 is softened to be in a flowable state, so that filler 3 is easily filled between holding member 1 and superconducting wire 2. Deformation (or dissolution) of holding member 1 can be prevented when the glass transition point of the second material is lower than the glass transition point of the first material. Furthermore, in this case, when the filling of filler 3 fails, filler 3 can be removed to perform filling process S2 again, so that a yield is improved.

This filling is more easily performed when the viscosity of the second material is relatively low (the viscosity of the second material is lower than the viscosity of the first material). In this case, the deformation of holding member 1 can be prevented when filler 3 is filled. In particular, because paraffin has a low melting point, it is easy to handle in filling process S2.

When the second material is paraffin or a foamed resin material, the superconducting wire 2 can be thermally insulated, so that evaporation of the refrigerant can be prevented while the power of heater 4 can be reduced. When the second material is a low melting point metal material such as a bismuth-based alloy, filler 3 can function as a protective layer when quenching is generated in superconducting wire 2 due to an eddy current.

When the protective layer on third portion 23c is removed in superconducting wire 2, the resistance of superconducting wire 2 can be efficiently increased by heating third portion 23c with heater 4, so that the persistent current switch can be easily configured. However, in this case, superconducting layer 23 (third portion 23c) is exposed from protective layer 24a and protective layer 24b. When the dew condensation is generated on the surface of superconducting layer 23 (third portion 23c), a superconducting characteristic of superconducting wire 2 is significantly degraded. According to the superconducting wire holding structure of the first embodiment, even when the protective layer on third portion 23c is removed in superconducting wire 2, the degradation of the superconducting characteristic of superconducting wire 2 due to the dew condensation on the surface of superconducting wire 2 can be prevented.

### (Second embodiment)

Hereinafter, a configuration of a superconducting wire holding structure according to a second embodiment will be described. In the following description, a difference from the configuration of the superconducting wire holding structure of the first embodiment will be mainly described, and overlapping description will not be repeated.

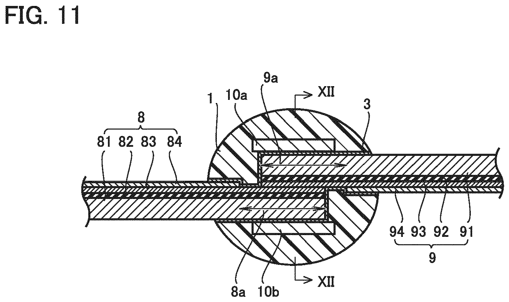

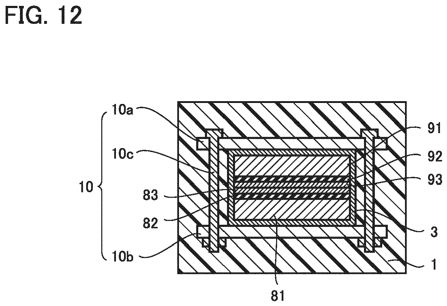

Fig. 11 is a schematic sectional view illustrating the superconducting wire holding structure of the second embodiment. Fig. 12 is a sectional view taken along a line XII-XII in Fig. 11. As illustrated in Figs. 11 and 12, the superconducting wire holding structure of the second embodiment includes a superconducting wire 8, a superconducting wire 9, holding member 1, and filler 3. The superconducting wire holding structure of the second embodiment may further include a jig 10.

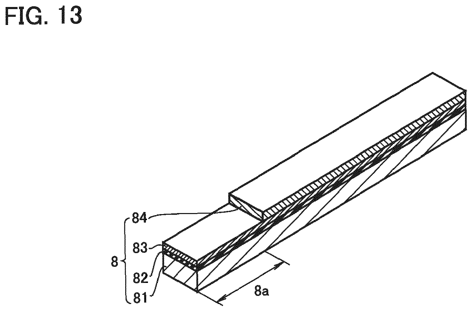

Fig. 13 is a sectional perspective view illustrating superconducting wire 8 in the superconducting wire holding structure of the second embodiment. As illustrated in Fig. 13, superconducting wire 8 includes a substrate 81, an intermediate layer 82, a superconducting layer 83, and a protective layer 84.

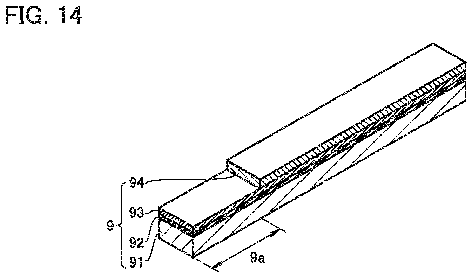

Fig. 14 is a sectional perspective view illustrating superconducting wire 9 in the superconducting wire holding structure of the second embodiment. As illustrated in Fig. 14, superconducting wire 9 includes a substrate 91, an intermediate layer 92, a superconducting layer 93, and a protective layer 94.

Substrate 81 and substrate 91 have the same configuration as substrate 21. Intermediate layer 82 and intermediate layer 92 have the same configuration as intermediate layer 22. Superconducting layer 83 and superconducting layer 93 have the same configuration as superconducting layer 23. Protective layer 84 is formed on superconducting layer 83. Protective layer 94 is formed on superconducting layer 93.

Superconducting wire 8 includes a first portion 8a at an end in the longitudinal direction of superconducting wire 8. In first portion 8a, protective layer 84 is removed. That is, in first portion 8a, superconducting layer 83 is exposed from the surface of superconducting wire 8. Superconducting wire 9 includes a second portion 9a at an end in the longitudinal direction of superconducting wire 9. In second portion 9a, protective layer 94 is removed. That is, in second portion 9a, superconducting layer 93 is exposed from the surface of superconducting wire 9.

As illustrated in Fig. 11, first portion 8a and second portion 9a are disposed inside holding member 1. Superconducting layer 83 located in first portion 8a and superconducting layer 93 located in second portion 9a are connected to each other while a connecting layer (not illustrated) made of the same oxide superconductor as superconducting layer 83 and superconducting layer 93 is interposed therebetween. Filler 3 is filled between holding member 1 and first portion 8a and second portion 9a.

For example, the material (first material) constituting holding member 1 is a resin material. The first material is preferably a thermosetting resin material. The second material is a resin material having a glass transition point lower than that of the first material.

Jig 10 includes a first member 10a, a second member 10b, and a fixing member 10c. For example, first member 10a and second member 10b are flat plate members. First member 10a and second member 10b are arranged to face each other with the superconducting wire 8 and the superconducting wire 9 interposed therebetween. Fixing member 10c is attached to first member 10a and second member 10b such that first member 10a and second member 10b sandwich superconducting wire 8 and superconducting wire 9. Thus, superconducting wire 8 and superconducting wire 9 are held by jig 10. For example, fixing member 10c includes a bolt and a nut. Jig 10 is disposed inside holding member 1 together with superconducting wire 8 and superconducting wire 9.

Hereinafter, a method for manufacturing the superconducting wire holding structure of the second embodiment will be described. In the following description, a difference from the method for manufacturing the superconducting wire holding structure of the first embodiment will be mainly described, and overlapping description will not be repeated.

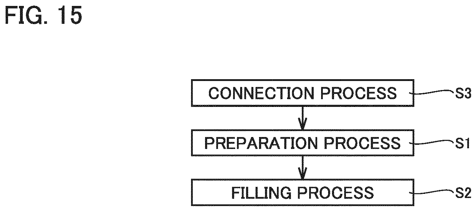

Fig. 15 is a process diagram illustrating the method for manufacturing the superconducting wire holding structure of the second embodiment. The method for manufacturing the superconducting wire holding structure of the second embodiment includes preparation process S1 and filling process S2. In this regard, the method for manufacturing the superconducting wire holding structure of the second embodiment is the same as the method for manufacturing the superconducting wire holding structure of the first embodiment.

The method for manufacturing the superconducting wire holding structure of the second embodiment further includes a connection process S3. Connection process S3 is performed before preparation process S1. In connection process S3, superconducting layer 83 located in second portion 9a and superconducting layer 93 located in second portion 9a are connected. This connection is performed using jig 10. In the method for manufacturing the superconducting wire holding structure of the second embodiment, first portion 8a and second portion 9b are disposed inside holding member 1 in preparation process S1. Regarding these points, the method for manufacturing the superconducting wire holding structure of the second embodiment is different from the method for manufacturing the superconducting wire holding structure of the first embodiment.

Hereinafter, an effect of the superconducting wire holding structure of the second embodiment will be described. In the following description, a difference from the effect of the superconducting wire holding structure of the first embodiment will be mainly described, and overlapping description will not be repeated.

Because superconducting layer 93 is exposed in second portion 9a while superconducting layer 83 is exposed in first portion 8a, the dew condensation may be generated on the surfaces of superconducting layer 83 and superconducting layer 93. Such dew condensation causes the degradation of the superconducting characteristics of superconducting layer 83 and superconducting layer 93. In the superconducting wire holding structure of the second embodiment, filler 3 is filled between first portion 8a and second portion 9a and holding member 1, so that the generation of the dew condensation as described above is prevented.

When the superconducting wire holding structure of the second embodiment includes jig 10 disposed inside holding member 1, connection strength between superconducting wire 8 and superconducting wire 9 can be increased. In this case, jig 10 has no need to be removed after connection process S3 is completed, so that the manufacturing process can be simplified. Furthermore, in this case, a decrease in yield due to the occurrence of an operation error during the removal of jig 10 can be prevented.

It should be understood that the first and second embodiments disclosed herein are illustrative in all respects and are not restrictive. The scope of the present invention is defined not by the first and second embodiments but by the claims, and is intended to include meanings equivalent to the claims and all modifications within the scope.

### REFERENCE SIGNS LIST

1: holding member, 2: superconducting wire, 2a: first end, 2b: second end, 3: filler, 4: heater, 5: persistent current switch, 6: superconducting coil, 7: case, 8: superconducting wire, 8a: first portion, 81: substrate, 82: intermediate layer, 83: superconducting layer, 84: protective layer, 9: superconducting wire, 9a: second portion, 91: substrate, 92: intermediate layer, 93: superconducting layer, 94: protective layer, 10: jig, 10a: first member, 10b: second member, 10c: fixing member, 21: substrate, 21a: first layer, 21b: second layer, 21c: third layer, 22: intermediate layer, 23: superconducting layer, 23a: first portion, 23b: second portion, 23c: third portion, 24, 24a, 24b: protective layer, PW: power source, S1: preparation process, S2: filling process, S3: connection process, SP: void

## Claims

1. A superconducting wire holding structure comprising:
a holding member (1) made of a first material;
a superconducting wire (2) disposed inside the holding member (1); and
a filler (3) made of a second material different from the first material,
wherein the superconducting wire (2) includes:
a substrate (21);
an intermediate layer (22) formed on the substrate (21);
a superconducting layer (23) formed on the intermediate layer (22); and **characterized in that**
a first protective layer (24a) and a second protective layer (24b) are formed on the superconducting layer (23),
**in that** the superconducting layer (23) includes a first portion (23a), a second portion (23b), and a third portion (23c) between the first portion (23a) and the second portion (23b) along a longitudinal direction of the superconducting wire (2),
**in that** the first protective layer (24a) is formed on the first portion (23a),
**in that** the second protective layer (24b) is formed on the second portion (23b), and **in that**
the filler (3) is filled between the third portion (23c) and the holding member (1).

2. The superconducting wire holding structure according to claim 1, wherein the first material is a first resin material, and
the second material is a second resin material.

3. The superconducting wire holding structure according to claim 2, wherein a glass transition point of the second resin material is lower than a glass transition point of the first resin material.

4. The superconducting wire holding structure according to claim 2, wherein viscosity of the second resin material is lower than viscosity of the first resin material.

5. The superconducting wire holding structure according to any one of claims 2 to 4, wherein the first resin material is a thermosetting resin, and
the second resin material is a thermoplastic resin.

6. The superconducting wire holding structure according to any one of claims 2 to 5, wherein the second resin material is paraffin.

7. The superconducting wire holding structure according to any one of claims 1 to 6, wherein the superconducting wire holding structure constitutes a persistent current switch.

8. The superconducting wire holding structure according to claim 1, wherein the first material is a resin material,
the second material is a metal material, and
a melting point of the metal material is lower than a glass transition point of the resin material.

9. The superconducting wire holding structure according to claim 8, wherein the resin material is a thermosetting resin.

10. The superconducting wire holding structure according to claim 8 or 9, wherein a melting point of the metal material is less than or equal to 200°C.

11. The superconducting wire holding structure according to any one of claims 8 to 10, wherein the metal material is a bismuth-based alloy.

12. A superconducting wire holding structure comprising:
a first superconducting wire (8) that includes a first superconducting layer (83);
a second superconducting wire (9) that includes a second superconducting layer (93);
a holding member (1) made of a first material; and
a filler (3) made of a second material different from the first material,
wherein the first superconducting wire (8) includes a first portion (8a) where the first superconducting layer (83) is exposed from a surface of the first superconducting wire (8) at an end in a longitudinal direction of the first superconducting wire (8),
the second superconducting wire (9) includes a second portion (9a) where the second superconducting layer (93) is exposed from a surface of the second superconducting wire (9) at an end in a longitudinal direction of the second superconducting wire (9),
the first portion (8a) and the second portion(9a) are disposed inside the holding member (1),
the first superconducting layer (83) located in the first portion (8a) and the second superconducting layer (93) located in the second portion (9a) are connected to each other, and
the filler (3) is filled between the holding member (1) and the first portion (8a) and the second portion (9a), **characterized in that**
the first material is a first resin material, and **in that**
the second material is a second resin material.

13. The superconducting wire holding structure according to claim 12, wherein a glass transition point of the second resin material is lower than a glass transition point of the first resin material.

14. The superconducting wire holding structure according to claim 12, wherein viscosity of the second resin material is lower than viscosity of the first resin material.

15. The superconducting wire holding structure according to claim 12, wherein the first resin material is a thermosetting resin, and
the second resin material is a thermoplastic resin.

16. The superconducting wire holding structure according to any one of claims 12 to 15, wherein the second resin material is paraffin.

## Patentansprüche

1. Haltestruktur für supraleitenden Draht, umfassend:
ein Halteelement (1), das aus einem ersten Material hergestellt ist;
einen supraleitenden Draht (2), der im Inneren des Halteelements (1) angeordnet ist; und
einen Füllstoff (3), der aus einem zweiten, vom ersten Material verschiedenen Material besteht,
wobei der supraleitende Draht (2) umfasst:
ein Substrat (21);
eine Zwischenschicht (22), die auf dem Substrat (21) ausgebildet ist;
eine supraleitende Schicht (23), die auf der Zwischenschicht (22) ausgebildet ist; und **gekennzeichnet ist durch**
eine erste Schutzschicht (24a) und eine zweite Schutzschicht (24b), ausgebildet auf der supraleitenden Schicht (23), und dass
die supraleitende Schicht (23) einen ersten Abschnitt (23a), einen zweiten Abschnitt (23b) und einen dritten Abschnitt (23c) zwischen dem ersten Abschnitt (23a) und dem zweiten Abschnitt (23b) entlang einer Längsrichtung des supraleitenden Drahtes (2) aufweist, und dass
die erste Schutzschicht (24a) auf dem ersten Abschnitt (23a) ausgebildet ist, und dass
die zweite Schutzschicht (24b) auf dem zweiten Abschnitt (23b) ausgebildet ist, und dass
der Füllstoff (3) zwischen dem dritten Abschnitt (23c) und dem Halteelement (1) eingefüllt wird.

2. Haltestruktur für supraleitenden Draht nach Anspruch 1, wobei das erste Material ein erstes Harzmaterial ist, und das zweite Material ein zweites Harzmaterial ist.

3. Haltestruktur für supraleitenden Draht nach Anspruch 2, wobei der Glasübergangspunkt des zweiten Harzmaterials niedriger ist als der Glasübergangspunkt des ersten Harzmaterials.

4. Haltestruktur für supraleitenden Draht nach Anspruch 2, wobei die Viskosität des zweiten Harzmaterials niedriger ist als die Viskosität des ersten Harzmaterials.

5. Haltestruktur für supraleitenden Draht nach einem der Ansprüche 2 bis 4, wobei das erste Harzmaterial ein wärmehärtendes Harz ist, und das zweite Harzmaterial ein thermoplastisches Harz ist.

6. Haltestruktur für supraleitenden Draht nach einem der Ansprüche 2 bis 5, wobei das zweite Harzmaterial Paraffin ist.

7. Haltestruktur für supraleitenden Draht nach einem der Ansprüche 1 bis 6, wobei die supraleitende Drahthaltestruktur einen Dauerstromschalter darstellt.

8. Haltestruktur für supraleitenden Draht nach Anspruch 1, wobei das erste Material ein Harzmaterial ist, das zweite Material ein Metallmaterial ist, und ein Schmelzpunkt des Metallmaterials niedriger ist als ein Glasübergangspunkt des Harzmaterials.

9. Haltestruktur für supraleitenden Draht nach Anspruch 8, wobei das Harzmaterial ein duroplastisches Harz ist.

10. Haltestruktur für supraleitenden Draht nach Anspruch 8 oder 9, wobei der Schmelzpunkt des Metallmaterials weniger als oder gleich 200°C beträgt.

11. Haltestruktur für supraleitenden Draht nach einem der Ansprüche 8 bis 10, wobei das Metallmaterial eine Legierung auf Wismutbasis ist.

12. Eine Haltestruktur für supraleitenden Draht, umfassend:
einen ersten supraleitenden Draht (8), der eine erste supraleitende Schicht (83) enthält;
einen zweiten supraleitenden Draht (9), der eine zweite supraleitende Schicht (93) enthält;
ein Halteelement (1) aus einem ersten Material; und
einen Füllstoff (3) aus einem zweiten Material, das sich von dem ersten Material unterscheidet,
wobei der erste supraleitende Draht (8) einen ersten Abschnitt (8a) aufweist, in dem die erste supraleitende Schicht (83) von einer Oberfläche des ersten supraleitenden Drahtes (8) an einem Ende in einer Längsrichtung des ersten supraleitenden Drahtes (8) freigelegt ist,
der zweite supraleitende Draht (9) einen zweiten Abschnitt (9a) aufweist, wo die zweite supraleitende Schicht (93) von einer Oberfläche des zweiten supraleitenden Drahtes (9) an einem Ende in einer Längsrichtung des zweiten supraleitenden Drahtes (9) freiliegt,
der erste Abschnitt (8a) und der zweite Abschnitt (9a) innerhalb des Halteelements (1) angeordnet sind,
die erste supraleitende Schicht (83), die sich in dem ersten Abschnitt (8a) befindet, und die zweite supraleitende Schicht (93), die sich in dem zweiten Abschnitt (9a) befindet, miteinander verbunden sind, und
der Füllstoff (3) zwischen dem Halteelement (1) und dem ersten Abschnitt (8a) und dem zweiten Abschnitt (9a) eingefüllt ist, **dadurch gekennzeichnet, dass**
das erste Material ein erstes Harzmaterial ist, und dass
das zweite Material ein zweites Harzmaterial ist.

13. Haltestruktur für supraleitenden Draht nach Anspruch 12, wobei der Glasübergangspunkt des zweiten Harzmaterials niedriger ist als der Glasübergangspunkt des ersten Harzmaterials.

14. Haltestruktur für supraleitenden Draht nach Anspruch 12, wobei die Viskosität des zweiten Harzmaterials niedriger ist als die Viskosität des ersten Harzmaterials.

15. Haltestruktur für supraleitenden Draht nach Anspruch 12, wobei das erste Harzmaterial ein wärmehärtendes Harz ist, und das zweite Harzmaterial ein thermoplastisches Harz ist.

16. Haltestruktur für supraleitenden Draht nach einem der Ansprüche 12 bis 15, wobei das zweite Harzmaterial Paraffin ist.

## Revendications

1. Structure de maintien de fil supraconducteur comprenant :
un élément de maintien (1) constitué d'un premier matériau ;
un fil supraconducteur (2) disposé à l'intérieur de l'élément de maintien (1) ; et
un matériau de remplissage (3) constitué d'un deuxième matériau différent du premier matériau,
dans laquelle le fil supraconducteur (2) comprend :
un substrat (21) ;
une couche intermédiaire (22) formée sur le substrat (21) ;
une couche supraconductrice (23) formée sur la couche intermédiaire (22) ; et
**caractérisée en ce que**
une première couche de protection (24a) et une deuxième couche de protection (24b) sont formées sur la couche supraconductrice (23),
la couche supraconductrice (23) comprend une première portion (23a), une deuxième portion (23b), et une troisième portion (23c) entre la première portion (23a) et la deuxième portion (23b) en direction longitudinale du fil supraconducteur (2),
la première couche de protection (24a) est formée sur la première portion (23a),
la deuxième couche de protection (24b) est formée sur la deuxième portion (23b), et
le matériau de remplissage (3) est rempli entre la troisième portion (23c) et l'élément de maintien (1).

2. Structure de maintien de fil supraconducteur selon la revendication 1, dans laquelle
le premier matériau est un premier matériau de résine, et
le deuxième matériau est un deuxième matériau de résine.

3. Structure de maintien de fil supraconducteur selon la revendication 2, dans laquelle
le point de transition vitreuse du deuxième matériau de résine est inférieur au point de transition vitreuse du premier matériau de résine.

4. Structure de maintien de fil supraconducteur selon la revendication 2, dans laquelle
la viscosité du deuxième matériau de résine est inférieure à la viscosité du premier matériau de résine.

5. Structure de maintien de fil supraconducteur selon l'une quelconque des revendications 2 à 4, dans laquelle
le premier matériau de résine est une résine thermodurcissable, et
le deuxième matériau de résine est une résine thermoplastique.

6. Structure de maintien de fil supraconducteur selon l'une quelconque des revendications 2 à 5, dans laquelle
le deuxième matériau de résine est une paraffine.

7. Structure de maintien de fil supraconducteur selon l'une quelconque des revendications 1 à 6, dans laquelle
la structure de maintien du fil supraconducteur constitue un commutateur de courant persistant.

8. Structure de maintien de fil supraconducteur selon la revendication 1, dans laquelle
le premier matériau est un matériau de résine,
le deuxième matériau est un matériau métallique, et
le point de fusion du matériau métallique est inférieur au point de transition vitreuse du matériau de résine.

9. Structure de maintien de fil supraconducteur selon la revendication 8, dans laquelle
le matériau de résine est une résine thermodurcissable.

10. Structure de maintien de fil supraconducteur selon la revendication 8 ou 9, dans laquelle
le point de fusion du matériau métallique est inférieur ou égal à 200 °C.

11. Structure de maintien de fil supraconducteur selon l'une quelconque des revendications 8 à 10, dans laquelle
le matériau métallique est un alliage à base de bismuth.

12. Structure de maintien de fil supraconducteur comprenant :
un premier fil supraconducteur (8) qui comprend une première couche supraconductrice (83) ;
un deuxième fil supraconducteur (9) qui comprend une deuxième couche supraconductrice (93) ;
un élément de maintien (1) constitué d'un premier matériau ; et
un matériau de remplissage (3) constitué d'un deuxième matériau différent du premier matériau,
dans laquelle le premier fil supraconducteur (8) comprend une première portion (8a) où la première couche supraconductrice (83) est exposée sur une surface du premier fil supraconducteur (8) à une extrémité en direction longitudinale du premier fil supraconducteur (8),
le deuxième fil supraconducteur (9) comprend une deuxième portion (9a) où la deuxième couche supraconductrice (93) est exposée sur une surface du deuxième fil supraconducteur (9) à une extrémité en direction longitudinale du deuxième fil supraconducteur (9),
la première portion (8a) et la deuxième portion (9a) sont disposées à l'intérieur de l'élément de maintien (1),
la première couche supraconductrice (83) située dans la première portion (8a) et la deuxième couche supraconductrice (93) située dans la deuxième portion (9a) sont connectées l'une à l'autre, et
le matériau de remplissage (3) est rempli entre l'élément de maintien (1) et la première portion (8a) et la deuxième portion (9a),
**caractérisée en ce que**
le premier matériau est un premier matériau de résine, et
le deuxième matériau est un deuxième matériau de résine.

13. Structure de maintien de fil supraconducteur selon la revendication 12, dans laquelle
le point de transition vitreuse du deuxième matériau de résine est inférieur au point de transition vitreuse du premier matériau de résine.

14. Structure de maintien de fil supraconducteur selon la revendication 12, dans laquelle
la viscosité du deuxième matériau de résine est inférieure à la viscosité du premier matériau de résine.

15. Structure de maintien de fil supraconducteur selon la revendication 12, dans laquelle
le premier matériau de résine est une résine thermodurcissable, et
le deuxième matériau de résine est une résine thermoplastique.

16. Structure de maintien de fil supraconducteur selon l'une quelconque des revendications 12 à 15, dans laquelle
le deuxième matériau de résine est une paraffine.
